# FASCICULE DE BREVET EUROPEEN

(11) **EP 4 123 688 B1**
(45) Date de publication et mention de la délivrance du brevet: **02.09.2026**
(21) Numéro de dépôt: 22185415.1
(22) Date de dépôt: 18.07.2022
(51) Int. Cl.: H10P 72/00, H10P 72/76

(54) **DISPOSITIF ET PROCÉDÉ DE COLLECTE D ÉLÉMENTS CONTAMINANTS SUR UNE PLAQUE DE MATÉRIAU SEMI-CONDUCTEUR**
VORRICHTUNG UND VERFAHREN ZUM SAMMELN VON KONTAMINIERENDEN ELEMENTEN AUF EINER PLATTE AUS HALBLEITERMATERIAL
DEVICE AND METHOD FOR COLLECTING CONTAMINANT ELEMENTS ON A SEMICONDUCTOR MATERIAL PLATE

(30) Priorité: 19.07.2021 FR 2107788
(43) Date de publication de la demande: 25.01.2023
(73) Titulaire: Commissariat à l'Energie Atomique et aux Energies Alternatives, 75015 Paris (FR)
(72) Inventeur: BOUTRY, Delphine, 38054 Grenoble Cedex 09 (FR); AUTILLO, Delphine, 38600 FONTAINE (FR); ENSENAT, Brice, 38054 GRENOBLE Cedex 09 (FR); LARDIN, Thierry, 38054 Grenoble Cedex 09 (FR)
(74) Mandataire: INNOV-GROUP

(56) Documents cités:
- EP-A1- 1 237 824
- EP-B1- 1 237 824
- US-A1- 2002 029 978
- US-A1- 2004 104 402
- US-B2- 7 138 016

## Description

### DOMAINE TECHNIQUE

Le domaine technique de l'invention est la collecte d'éléments contaminants sur un substrat, notamment un substrat en microélectronique.

### ART ANTERIEUR

Dans l'industrie microélectronique, on utilise des substrats, usuellement désignés par le terme « wafer ». Il s'agit de plaques circulaires, rigides et fines, sur lesquelles on effectue des étapes de microfabrication, de type dépôts de couches, gravures, et photolithographie. Le diamètre des plaques peut par exemple être égal à 100 mm ou 150 mm ou 200 mm ou 300 mm. Chaque plaque peut comporter plusieurs centaines de puces électroniques. Chaque puce peut comporter un nombre très élevé de transistors, par exemple de l'ordre de 1.10⁹ transistors par puces. Généralement, les substrats sont en silicium. Chaque plaque s'étend entre une face avant et une face arrière, selon une épaisseur. Les étapes de microfabrication sont généralement mises en œuvre au niveau de la face avant.

Le passage d'une plaque de silicium vierge à une plaque finalisée nécessite plusieurs mois de production, au cours desquels on effectue des centaines d'étapes de fabrication de façon à former une multitude de puces sur la plaque. La plaque peut être transportée entre différents équipements. Elle peut également être temporairement stockée entre deux étapes de fabrication. Afin de ne pas compromettre les performances des puces, la maîtrise de la contamination constitue un enjeu particulièrement critique. En effet, une particule d'un élément non souhaité ou une poussière de dimension submicronique se déposant sur une plaque peut rendre une puce inutilisable. Afin d'adresser la question de la contamination, c'est-à-dire la présence d'éléments (poussières, particules) indésirables, les opérations de microfabrication sur des substrats de silicium sont effectuées en salle blanche, dans des environnements propres et contrôlés.

Les plaques sont généralement manipulées par une préhension de leur périphérie ou de leur face arrière. C'est donc sur ces parties que le risque de contamination des plaques est maximal. Il est donc important de caractériser la contamination affectant les plaques. Par caractérisation, on entend l'identification et la quantification des contaminants. Selon une possibilité, on fait circuler une goutte de liquide nettoyant le long de la périphérie d'une plaque. Le liquide nettoyant est susceptible de collecter les éléments indésirables. La goutte est ensuite récupérée et analysée par des méthodes d'analyses destructives, par exemple par spectrométrie de masse à couplage inductif, usuellement désignée par l'acronyme ICPMS (Induced Coupled Plasma Mass spectrometry), ou par spectrométrie de fluorescence X. Préalablement à l'application du liquide, la plaque peut faire l'objet d'un traitement de surface à une vapeur d'acide fluorhydrique, de façon à rendre la plaque hydrophobe. La succession de traitement par vapeur et collecte du liquide est usuellement désignée VPD-DC (Vapor Phase Decomposition - Droplet Collection, signifiant décomposition en phase vapeur - collecte de goutte).

Les documents US2002/0029978 et US2004/0104402 décrivent des dispositifs destinés à permettre une application d'une solution contre une bordure d'un wafer. Pour cela, un joint circulaire permet d'assurer une étanchéité entre une partie centrale du wafer et une partie périphérique, de façon que seule la partie périphérique est mouillée.

Le document FR3091009 décrit un procédé dans lequel la périphérie d'une plaque est plongée dans une rainure comportant un liquide nettoyant. Le liquide nettoyant est propice à une collecte d'éléments indésirables déposés sur la périphérie de la plaque. Un tel procédé permet une meilleure maîtrise de la surface de la plaque mise en contact avec le liquide nettoyant.

Cependant, certaines plaques sont formées d'un matériau trop mouillant à l'égard du liquide nettoyant, et s'accommodant mal d'un traitement de surface par vaporisation. Il s'agit de matériaux tels que SiC (carbure de silicium) SiN (Nitrure de Silicium) ou SiO₂ (dioxyde de Silicium). Les inventeurs proposent un procédé alternatif, mettant en œuvre un dispositif spécifique, ne nécessitant pas le recours à un traitement préalable de surface visant à modifier la mouillabilité de la plaque. Le dispositif permet une collecte efficace de contaminants indépendamment des propriétés de mouillabilité du matériau formant la plaque. Il permet également de maîtriser la quantité de liquide nettoyant utilisée, et de contrôler l'étendue de la plaque traitée par le liquide.

### EXPOSE DE L'INVENTION

Un premier objet de l'invention est un dispositif de nettoyage d'une plaque de semi-conducteur, tel que définit dans la revendication 1.

Les revendications 2 à 12 définissent différents modes de réalisation.

Un deuxième objet de l'invention est un procédé de collecte d'éléments contaminants susceptibles d'être présents sur une plaque de semi-conducteur, à l'aide d'un dispositif selon le premier objet de l'invention, le procédé comportant :
a) disposition de la plaque sur la zone d'appui du dispositif ;
b) admission d'un liquide nettoyant dans la cavité annulaire, de façon que le liquide mouille une partie de la plaque s'étendant dans la cavité annulaire ;
c) retrait du liquide nettoyant de la cavité annulaire;
d) retrait de la plaque de la zone d'appui.

Selon un mode de réalisation, le dispositif est un dispositif comportant un capot et un support tels que précédemment définis. Le procédé est tel que
- lors de l'étape a) et de l'étape d) le capot est séparé du support;
- suite à l'étape a) et avant l'étape b), le capot est placé sur le support.

Un troisième objet de l'invention est un procédé de fabrication d'un dispositif selon le premier objet de l'invention, le dispositif étant fabriqué par moulage ou par impression 3D.

### FIGURES

La figure 1A est une vue en coupe d'une plaque de semi-conducteur, usuellement désignée par le terme « wafer », terme anglosaxon signifiant « gaufrette ».
La figure 1B est une vue d'une plaque de semi-conducteur.
La figure 1C est un détail d'une extrémité de la plaque décrite en lien avec les figures 1A et 1B.
La figure 2A est une vue tridimensionnelle d'un support, faisant partie du dispositif, selon un premier mode de réalisation.
La figure 2B est une vue en coupe du support schématisé sur la figure 2A, la coupe étant effectuée selon un plan parallèle à un premier axe central, autour duquel s'étend le support, et passant par ce dernier.
La figure 2C montre une plaque disposée sur le support.
La figure 2D est une vue tridimensionnelle d'un capot, faisant partie du dispositif, selon le premier mode de réalisation.
La figure 2E est une vue en coupe du capot schématisé sur la figure 2D, la coupe étant effectuée selon un plan parallèle à un deuxième axe central, autour duquel s'étend le capot, et passant par ce dernier.
La figure 2F est une autre vue en coupe du capot schématisé sur la figure 2E, la coupe étant effectuée selon un plan parallèle au deuxième axe central et passant par ce dernier ainsi que par une ouverture fluidique s'étendant à travers le support.
Les figures 2G, 2H et 2I représentent le dispositif formé par le capot assemblé sur le support, respectivement en l'absence de plaque, en présence d'une plaque disposée dans le logement défini par le dispositif, et en présence d'un liquide nettoyant dans une cavité annulaire du dispositif.
La figure 3A montre un capot selon un autre mode de réalisation.
La figure 3B illustre un mode de réalisation dans lequel la face supérieure, ménagée dans le support, comporte une gorge annulaire.
La figure 3C schématise un mode de réalisation dans lequel le capot est annulaire.
   Il en est de même de la figure 3D.
La figure 3E schématise un mode de réalisation dans lequel le support et le capot sont annulaires.
La figure 4A est une vue tridimensionnelle d'un mode de réalisation, dans lequel le support et le capot sont annulaires.
La figure 4B est une vue tridimensionnelle d'un autre mode de réalisation dans lequel le support et le capot sont annulaires.
La figure 4C est un détail de la figure 4B.
La figure 5 schématise les principales étapes d'un procédé de collecte d'éléments contaminants susceptibles d'être présents sur une plaque, en utilisant d'un dispositif selon l'invention.

### EXPOSE DE MODES DE REALISATION PARTICULIERS

Dans la suite du texte, le terme plaque désigne un substrat, en particulier un substrat à base de semi-conducteur, par exemple, et de façon non limitative, du silicium, du nitrure de silicium, du carbure de silicium. La plaque peut notamment être une plaque circulaire.

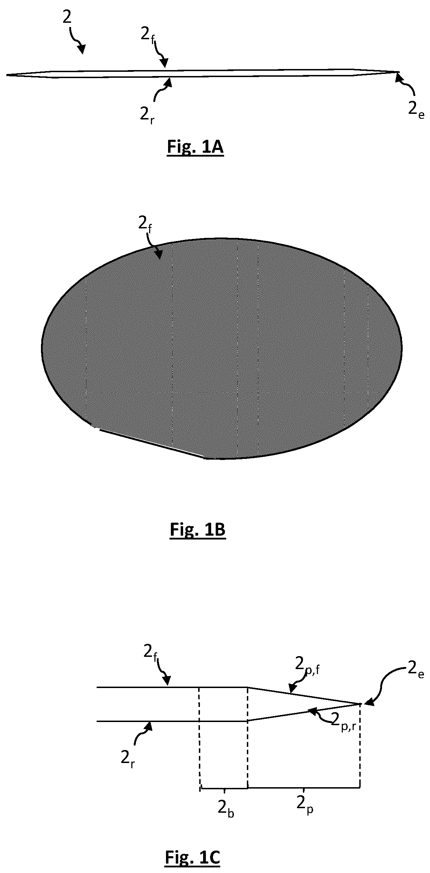

On a représenté, sur les figures 1A à 1C, une plaque 2, comportant une surface avant 2_{f} et une surface arrière 2ᵣ. La plaque 2 est délimitée par une périphérie biseautée (ou bevel) circulaire 2ₚ. Au niveau de la périphérie biseautée, la plaque s'amincit progressivement jusqu'à une extrémité radiale 2ₑ. Le diamètre de la plaque 2 peut être inférieur ou égal à 100 mm ou égal à 150 mm ou 200 mm ou à 300 mm, voire davantage. D'une façon générale, le diamètre est de préférence compris entre 100 mm et 450 mm. La surface avant 2_{f} s'étend parallèlement à la surface arrière 2ᵣ. La plaque 2 comporte une bordure 2_{b}, adjacente de la périphérie 2ₚ. La bordure s'étend généralement, radialement, selon une largeur inférieure à 1 cm à partir de la périphérie biseautée 2ₚ. Le bevel (biseau) 2ₚ comporte une partie 2_{p,f} côté surface avant, et une partie 2_{p,r} côté surface arrière.

C'est surtout au niveau de la bordure 2_{b} ou de la périphérie biseautée 2ₚ que des éléments contaminants sont susceptibles d'être présents. Le dispositif décrit ci-après est destiné à être utilisé pour collecter de tels éléments contaminants. Les éléments contaminants peuvent être des poussières ou des espèces métalliques, par exemple Fe, Cr, Al, Ni, Cu, Ti, Ga, Co, Au, Ag, Pt.

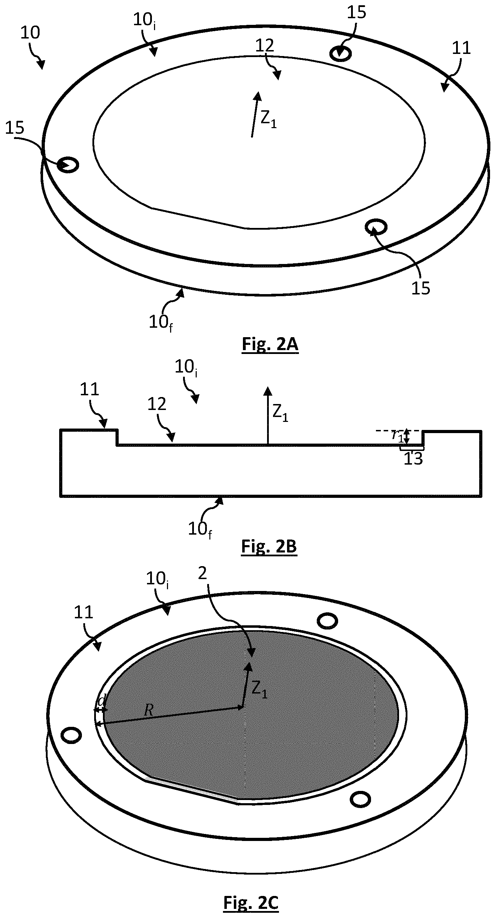

Les figures 2A à 2I représentent un premier mode de réalisation d'un dispositif 1 selon l'invention. Selon ce premier mode de réalisation, le dispositif est formé par l'assemblage d'un support et d'un capot. Le support est décrit en lien avec les figures 2A à 2C. Le support s'étend, parallèlement à un premier axe central Z₁, entre un fond 10_{f} et une face, dite face inférieure 10ᵢ. La face inférieure 10ᵢ est délimitée par une bordure inférieure 11 annulaire, s'étendant autour du premier axe central Z₁.

La face inférieure 10ᵢ comporte une zone d'appui 12, destinée à recevoir la plaque 2, de telle sorte que la plaque 2 s'appuie contre la zone d'appui 12. Dans cet exemple, la zone d'appui 12 est de forme circulaire, en étant délimitée, radialement, par la bordure inférieure 11. Elle s'étend radialement entre la bordure inférieure 11 et le premier axe central Z₁. Par radialement, on entend selon une direction perpendiculaire à l'axe central. La forme de la zone d'appui 12 correspond à la forme de la plaque 2. Selon une possibilité, la zone d'appui 12 peut affleurer, parallèlement au premier axe central Z₁, la bordure inférieure 11. De préférence, comme cela est représenté sur la figure 2B, la zone d'appui 12 est disposée en retrait par rapport à la bordure inférieure 11. Le retrait *r*₁, parallèlement au premier axe central Z₁, correspond à tout ou partie de l'épaisseur ε de la plaque 2. Il peut être par exemple égal à la demi-épaisseur de la plaque. La figure 2B représente une vue en coupe du support 10, selon un plan de coupe comportant le premier axe central.

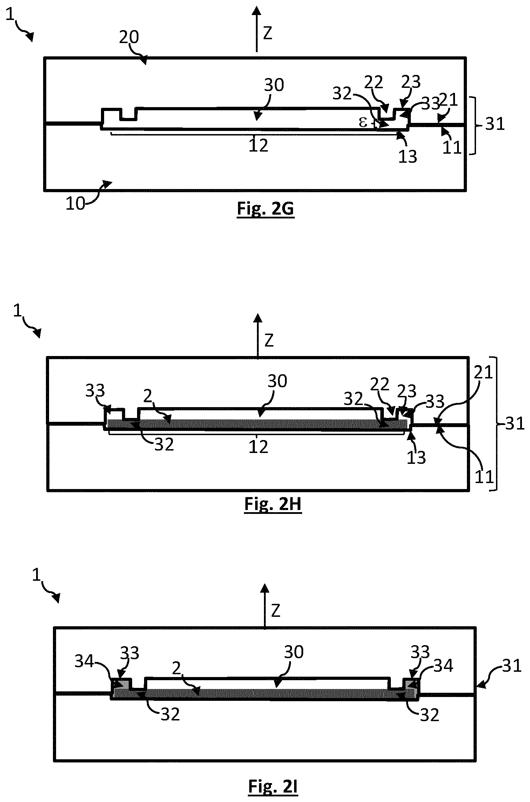

La face inférieure 10ᵢ comporte une portion de confinement 13, adjacente de la bordure inférieure 11, et s'étendant radialement sur quelques mm, voire 1 cm, à partir de cette dernière. La fonction de la portion de confinement 13 est décrite en lien avec la figure 2G. La portion de confinement s'étend entre la zone d'appui 12 et la bordure inférieure 11. La portion de confinement peut chevaucher une partie de la zone d'appui 12.

Le support 10 comporte trois ouvertures d'assemblage 15 configurées pour recevoir un moyen d'assemblage. Le moyen d'assemblage est destiné à assembler le support 10 à un capot 20 décrit par la suite. Les ouvertures d'assemblage 15 peuvent être des ouvertures taraudées configurées pour recevoir des vis.

La figure 2C montre une plaque 2 reposant sur la zone d'appui 12 du support 10. Le support 10 est de préférence dimensionné de telle sorte que lorsque la plaque 2 est maintenue par la zone d'appui 12, la plaque est disposée à une distance *d* non nulle de la bordure inférieure 11. La distance *d* peut être comprise entre 1 mm et 10 mm, et de préférence égale à 5 mm ± 2 mm ou ± 3 mm. Ainsi, la bordure inférieure 11 est agencée de façon à s'étendre radialement, autour du premier axe central Z₁, à partir d'un rayon *R* correspondant au rayon de la plaque additionné de la distance *d.* En fonction du rayon de la plaque, le rayon *R* est compris entre quelques cm et quelques dizaines de cm.

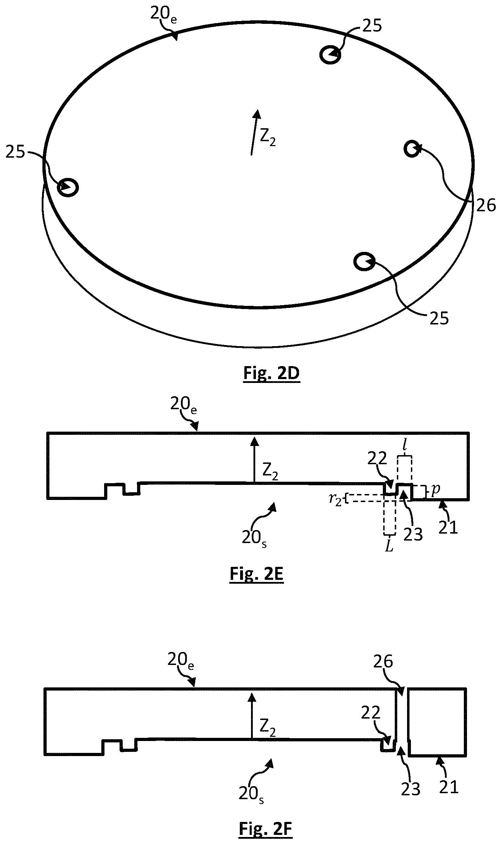

Les figures 2D, 2E et 2F montrent le capot 20 du dispositif 1. Le capot 20 est destiné à être assemblé sur le support 10, comme représenté sur la figure 2G. Le capot 20 s'étend, selon un deuxième axe central Z₂, entre une face, dite face supérieure 20ₛ et une face externe 20ₑ. Lors de l'assemblage du capot 20 sur le support 10:
- la face supérieure 20ₛ est appliquée en regard de la face inférieure 10ᵢ du support;
- le premier axe central Z₁ et le deuxième axe central Z₂ sont confondus et forment un même axe central Z.

La face supérieure 20ₛ est délimitée par une bordure supérieure 21, annulaire, s'étendant autour du deuxième axe central Z₂. La face supérieure 20ₛ comporte une zone de contact 22, annulaire autour du deuxième axe central Z₂ et destinée à entrer en contact avec la plaque 2. La zone de contact 22 s'étend radialement entre la bordure supérieure 21 et le deuxième axe central Z₂. La zone de contact 22 peut affleurer la bordure supérieure 21. De préférence, comme cela est représenté sur la figure 2D, la zone de contact 22 est disposée en retrait par rapport à la bordure supérieure 21. Le retrait *r*₂, selon le deuxième axe central Z₂, correspond à tout ou partie de l'épaisseur de la plaque 2. Le retrait *r*₂ peut être par exemple égal à la demi-épaisseur de la plaque. La largeur radiale *L* de la zone de contact 22 est de quelques millimètres ou de quelques cm, par exemple entre 2 mm et 15 mm.

La somme du premier retrait *r*₁, décrit en lien avec la figure 2B, et du deuxième retrait *r*₂, correspond de préférence à l'épaisseur ε de la plaque 2.

La face supérieure 20ₛ comporte une gorge supérieure 23. La gorge supérieure 23 est annulaire, autour du deuxième axe central Z₂. La gorge supérieure 23 est délimitée radialement d'une part par la zone de contact 22, d'autre part par la bordure supérieure 21. La profondeur *p* de la gorge supérieure 23, parallèlement au deuxième axe central Z₂, est millimétrique, en étant comprise entre 1 mm et 10 mm, par exemple 5 mm ± 2 mm ou ± 3 mm. La largeur radiale *l* de la gorge supérieure 23 est comprise entre 1 mm et 10 mm, par exemple 5 mm ± 2 mm ou ± 3 mm.

Le capot 20 comporte des ouvertures d'assemblage 25, destinées à être disposées en vis-à-vis des ouvertures d'assemblages 15 pratiquées dans le support 10. Ainsi, lors de l'assemblage, chaque ouverture d'assemblage 15 du support 10 prolonge une ouverture d'assemblage 25 du capot 20.

Le capot 20 comporte au moins une ouverture fluidique 26, débouchant dans la gorge supérieure 23. L'ouverture fluidique 26 est destinée à l'admission d'un liquide nettoyant 34 dans la gorge supérieure 23 ou au retrait du liquide nettoyant de la gorge supérieure 23. La figure 2F est une vue en coupe du capot 20, dans un plan parallèle au deuxième axe central Z₂ et passant par l'ouverture fluidique 26.

L'ouverture fluidique 26 peut être circulaire, comme représenté sur la figure 2D, ou s'étendre selon une portion d'un anneau, comme décrit par la suite.

La figure 2G montre une vue en coupe du dispositif 1 formé par l'assemblage du capot 20 sur le support 10. Dans cet exemple, la plaque n'a pas été placée sur le support 10. Après l'assemblage :
- le premier axe central Z₁ et le deuxième axe central Z₂ sont coaxiaux et forment un même axe central Z.
- La bordure supérieure 21 du capot 20 vient au contact de la bordure inférieure 11 du support 10, de manière à former une bordure annulaire 31 ;
- La zone de contact 22 du capot 20 s'étend face à la zone d'appui 12 du support 10. L'espacement entre la zone de contact 22 et la zone d'appui 12 correspond sensiblement à l'épaisseur ε de la plaque 2. Par sensiblement, on entend que l'espacement est supérieur ou égal à l'épaisseur de la plaque, de manière à permettre un maintien de la plaque entre la zone de contact 22 et la zone d'appui 12. La zone d'appui 12 et la zone de contact 22 délimitent alors une fente annulaire 32, dans laquelle la plaque peut être insérée. La fente annulaire 32 s'étend radialement entre l'axe central Z et la bordure annulaire 31. La fente annulaire 32 s'étend de préférence radialement parallèlement à un axe perpendiculaire à l'axe transversal, entre la zone d'appui 12 et la zone de contact 22.
- La gorge supérieure 23 s'étend en regard de la portion de confinement 13 de la face inférieure 10ᵢ du support 10.
- L'espace entre la face inférieure 10ᵢ et la face supérieure 20ₛ forme un logement 30, dans lequel la plaque peut, au moins en partie, s'étendre.

La figure 2H montre une vue en coupe du dispositif 1 formé par l'assemblage du capot 20 sur le support 10. Dans cet exemple, la plaque a été placée sur le support 10. Un aspect important de l'invention est que lorsque la plaque est disposée sur le support 10, après l'assemblage du capot 20 sur le support 10, la gorge supérieure 23 et la portion de confinement 13, délimitées, radialement d'une part par la zone de contact 22 et la zone d'appui 12, et d'autre part par les bordures inférieure et supérieure, forment une cavité annulaire 33. La fente 32 est de préférence dimensionnée pour que, suite à l'insertion de la plaque dans la fente, la cavité annulaire 33 soit étanche.

L'ouverture fluidique 26 débouche dans la cavité annulaire 33 et permet à cette dernière d'être remplie par un liquide, en particulier un liquide nettoyant 34. La figure 2I montre le dispositif 1 dans lequel la cavité annulaire 33 est remplie de liquide nettoyant 34, ce dernier étant matérialisé en grisé.

Le liquide nettoyant 34 peut être une solution à base d'acide chlorhydrique, ou d'acide nitrique ou d'acide fluorhydrique, ou d'eau oxygénée ou eau. Le liquide nettoyant 34 est maintenu, durant une période prédéterminée, dans la cavité 33, au contact de la plaque 2, et plus précisément au contact de la partie de plaque s'étendant dans la cavité 33. Le liquide nettoyant 34 est ensuite évacué de la cavité 33 par un moyen d'aspiration, puis analysé par une méthode d'analyse telle que décrite dans l'art antérieur. Le dispositif 1 est ensuite désassemblé et la plaque 2 peut être retirée.

Compte tenu des dimensions de la cavité annulaire 33, en fonction du diamètre de la plaque 2, le volume de liquide nettoyant 34 pour remplir la cavité 33 est typiquement de quelques dizaines de mL.

Un avantage de l'invention est de maîtriser la surface de la plaque mouillée par le liquide nettoyant 34. Il s'agit de la surface de la plaque débouchant dans la cavité 33. De préférence, le dispositif est dimensionné pour analyser une surface de plaque qui s'étend de quelques millimètres à partir de l'extrémité radiale 2ₑ de la plaque. La partie de la plaque au contact du liquide nettoyant 34 comporte la partie périphérique biseautée 2ₚ (bevel) ainsi que, partiellement ou en totalité, la bordure 2_{b}.

L'invention permet également de maîtriser le volume de liquide nettoyant 34 agissant sur la plaque, ce dernier étant inférieur ou égal au volume de la cavité 33. La mise en œuvre de l'invention n'est pas dépendante de propriétés de mouillage du matériau formant la plaque 2 à l'égard du liquide nettoyant 34. Ainsi, il n'est pas nécessaire d'effectuer un prétraitement visant à modifier la mouillabilité du matériau formant la plaque.

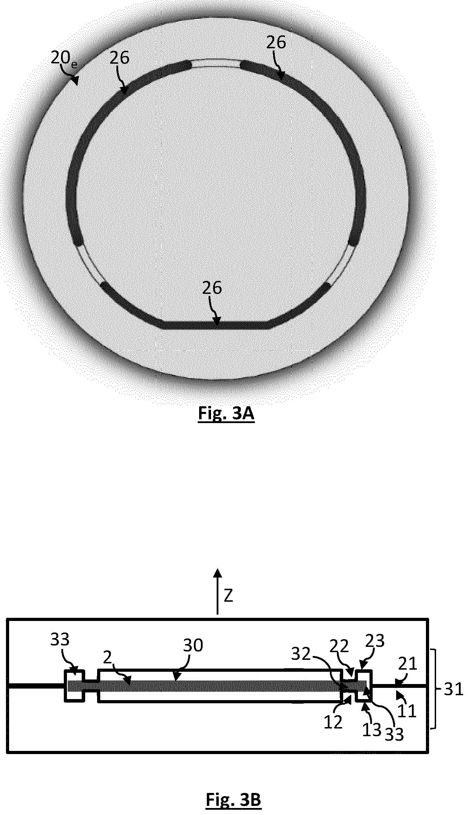

La figure 3A représente un mode de réalisation dans lequel le capot 20 comporte une ouverture fluidique 26 formant une partie d'un anneau. Dans cet exemple, le capot comporte trois ouvertures fluidiques annulaires 26 séparées les unes des autres. Une telle forme facilite l'admission ou l'évacuation du liquide nettoyant 34.

La figure 3B illustre un mode de réalisation dans lequel la portion de confinement 13 de la face inférieure 10ᵢ forme une gorge inférieure 13, dont les dimensions sont comparables à la gorge supérieure 23 ménagée au niveau de la face supérieure 20ₛ du capot 20. Les gorges 23 et 13 délimitent la cavité annulaire 33. La gorge inférieure 13 s'étend entre la zone d'appui 12 et la bordure inférieure 11. Dans l'exemple représenté, la zone d'appui 12 est annulaire, autour de l'axe central Z, en vis-à-vis de la zone de contact 22, cette dernière étant également annulaire. Un tel mode de réalisation permet un meilleur accès du liquide nettoyant 34 sur la surface arrière 2ᵣ de la plaque, et en particulier sur la partie périphérique arrière biseautée 2_{p,r}.

Ainsi, le dispositif comporte une cavité annulaire 33, s'étendant entre la fente annulaire 32, délimitée par la zone d'appui 12 et la zone de contact 22. La cavité annulaire 33 peut être formée par la gorge supérieure 23, s'étendant entre la zone de contact 22 et la bordure annulaire 31 et/ou la gorge inférieure 13, s'étendant entre la zone d'appui 12 et la bordure annulaire 31.

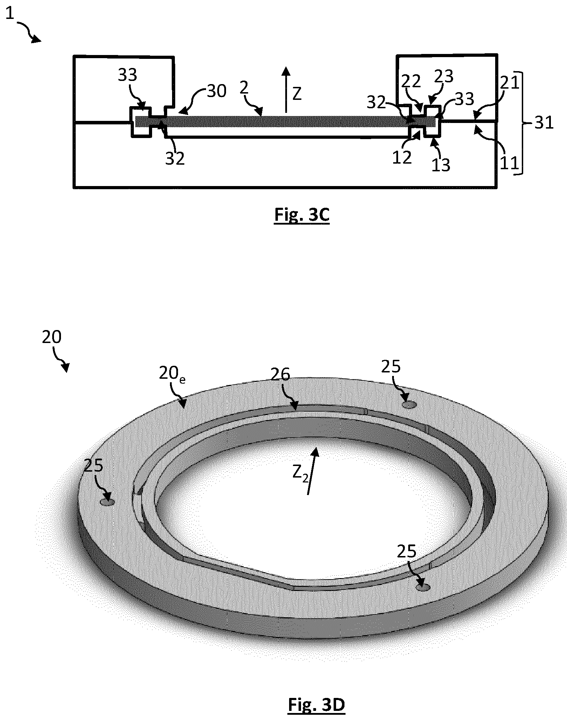

La figure 3C représente un mode de réalisation dans lequel le capot 20 est annulaire, autour du deuxième axe central Z₂. Le capot 20 est creux entre l'axe central Z et la zone de contact 22. Un tel mode de réalisation permet une meilleure visibilité de la surface avant de la plaque lorsque cette dernière est insérée dans le dispositif 1. Cela permet également d'appliquer un autre traitement nettoyant sur la surface supérieure 2ₛ de la plaque 2. La figure 3D représente une vue tridimensionnelle du capot annulaire 20. Selon ce mode de réalisation, la gorge supérieure 23 est traversante et débouche sur la face externe 20ₑ du capot 20. La gorge supérieure 23 fait alors office d'ouverture fluidique 26.

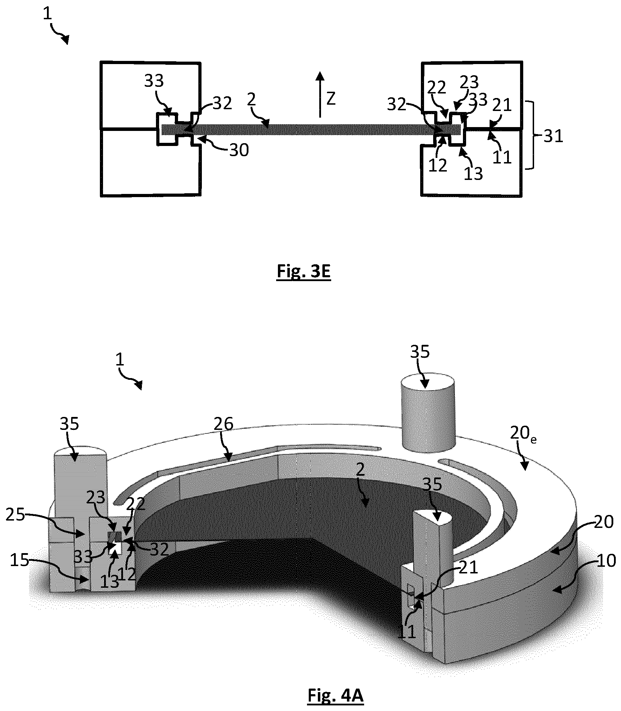

La figure 3E montre un mode de réalisation dans lequel le support 10 et le capot 20 sont annulaires. Le support est creux entre l'axe central Z et la zone d'appui 12. Le logement 30, destiné à recevoir la plaque est ainsi annulaire. Un tel mode de réalisation est représenté sur la figure 4A. Sur la figure 4A, les moyens d'assemblage sont des vis 35, traversant les ouvertures d'assemblage 25 et 15 respectivement ménagées dans le capot 20 et le support 10. Sur la figure 4A, la face inférieure 10ᵢ du support 10 comporte une gorge annulaire inférieure 13 telle que décrite en lien avec la figure 3B. La zone d'appui 12 forme une protubérance annulaire sur la face inférieure 10ᵢ. Cela permet de limiter la zone de contact entre la face arrière de la plaque et la zone d'appui 12.

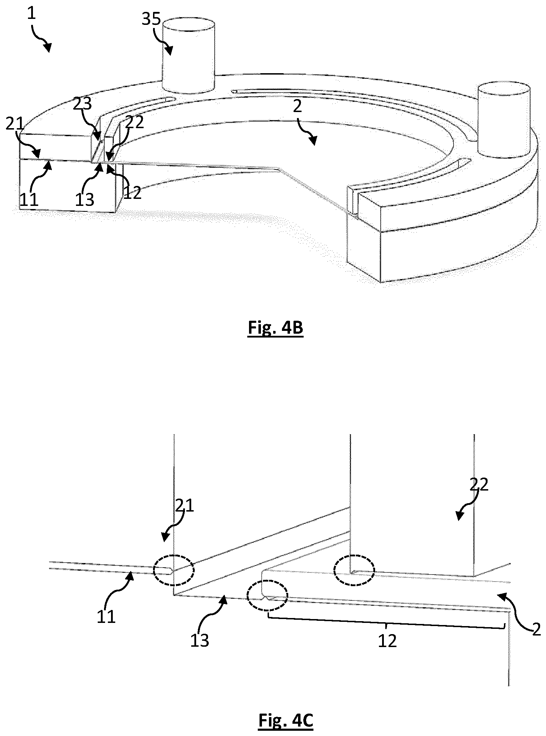

La figure 4B représente un mode de réalisation analogue à celui de la figure 4A, la zone d'appui 12 étant plane. Selon ce mode de réalisation, la portion de confinement 13 est plane, et s'étend entre la zone d'appui 12 et la bordure inférieure 11. Un tel mode de réalisation permet principalement un nettoyage de la partie supérieure du bevel 2_{p,f} et de la bordure 2_{b} de la plaque.

Quel que soit le mode de réalisation, les parties destinées à être en contact avec la plaque sont formées dans un matériau constitué de Téflon ou comportant du Téflon. Il s'agit en particulier de la zone d'appui 12 et de la zone de contact 22. Il peut en être des bordures inférieure et supérieure. Selon une possibilité, le capot et le support sont constitués de Téflon. Le Téflon présente l'avantage de résister à l'utilisation de liquides nettoyants agressifs, sans relarguer des éléments contaminants.

Afin d'améliorer l'étanchéité entre deux surfaces jointives, des lèvres peuvent être formées dans au moins une des deux surfaces destinées à être assemblées l'une à l'autre. La figure 4C est un détail de la configuration représentée sur la figure 4B. Les lèvres d'étanchéité sont contournées par des cercles en pointillés. Des lèvres peuvent être ménagées sur la bordure inférieure 11 et/ou sur la bordure supérieure 21. Cela améliore l'étanchéité lors de l'application de la bordure supérieure contre la bordure inférieure. Des lèvres peuvent être ménagées au niveau de la fente, sur la zone de contact 22 ou sur la zone d'appui 12, les lèvres étant alors destinées à s'appuyer contre la plaque pour former un joint.

Le dispositif peut prendre une configuration différente d'un support disposé sur un capot. Il peut par exemple être formé de deux parties symétriques l'une de l'autre par rapport à un plan passant par l'axe central Z.

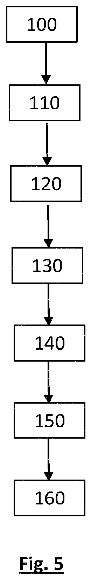

La figure 5 schématise les principales étapes d'un procédé de collecte d'éléments indésirables susceptibles d'être présents au niveau d'une plaque 2.

Etape 100 : disposition de la plaque sur le support 10, la plaque reposant sur la zone d'appui 12, une portion périphérique de la plaque s'étendant entre la zone d'appui 12 et la bordure inférieure 11, sur la portion de confinement 13.

Etape 110 : application du capot 20 sur le support 10, de telle sorte que la zone de contact 22 vienne en appui sur la plaque 2. La plaque est disposée entre le capot et le support.

Etape 120 : admission du liquide nettoyant 34, propice à la collecte d'éléments présents à la surface de la plaque, dans la cavité 33, de telle sorte que le liquide mouille une partie de la plaque s'étendant dans la gorge annulaire.

Etape 130 : action du liquide nettoyant 34 sur les parties de la plaque mises au contact de ce dernier, dans la cavité 33.

Etape 140 : évacuation du liquide pour analyse.

Etape 150 : retrait du capot 20 et retrait de la plaque du support 10.

Etape 160 : analyse du liquide nettoyant 34, de façon à identifier les éventuels éléments contaminants retirés de la plaque et, si besoin, déterminer leur concentration dans le liquide, sachant que le volume de liquide introduit est connu. Cette étape est optionnelle.

Le support et le capot peuvent être fabriqués par moulage, ou par impression 3D (en trois dimensions).

## Revendications

1. Dispositif (1) de nettoyage d'une plaque de semi-conducteur, la plaque (2) comportant une surface avant (2_{f}) et une surface arrière (2ᵣ), les surfaces avant et arrière étant espacées d'une épaisseur de la plaque (ε), le dispositif comportant un logement (30), destiné à recevoir la plaque, le logement étant délimité par une bordure annulaire (31) s'étendant autour d'un axe central (Z), le logement comportant :
- une zone d'appui (12), destinée à recevoir la plaque, la zone d'appui (12) s'étendant entre l'axe central (Z) et la bordure annulaire (31);
- une zone de contact (22), annulaire autour de l'axe central, s'étendant face à la zone d'appui (12), la distance, selon l'axe central, entre la zone de contact et la zone d'appui étant supérieure ou égale à l'épaisseur de la plaque (ε), la zone d'appui et la zone de contact délimitant ainsi une fente (32), s'étendant entre l'axe central et la bordure annulaire (31), de telle sorte que la plaque puisse être insérée à travers la fente ;
- une cavité (33), annulaire autour de l'axe central (Z), s'étendant radialement entre la fente (32) et la bordure annulaire (31), autour de la plaque, la cavité annulaire étant configurée pour contenir un liquide nettoyant (34);
- de telle sorte que lorsque la cavité annulaire (33) contient le liquide nettoyant (34), la plaque (2), insérée dans la fente (32), est mouillée par le liquide nettoyant, entre la fente (32) et la bordure annulaire (33), le liquide nettoyant s'étendant autour de la plaque ;
- le dispositif étant tel que la zone d'appui (12) et la zone de contact (22) sont formées dans un matériau constitué de Téflon ou comportant du Téflon.

2. Dispositif selon la revendication 1, dans lequel la cavité annulaire (33) comporte une gorge annulaire supérieure (23), s'étendant radialement entre la zone de contact (22) et la bordure annulaire (31).

3. Dispositif selon l'une quelconque des revendications 1 ou 2, dans lequel la cavité annulaire (33) comporte une gorge annulaire inférieure (13), s'étendant radialement entre la zone d'appui (12) et la bordure annulaire (31).

4. Dispositif selon l'une quelconque des revendications précédentes, dans lequel le logement (30) s'étend entre une face inférieure (10ᵢ) et une face supérieure (20ₛ), le dispositif étant tel que :
- la face inférieure (10ᵢ) et la face supérieure (20ₛ) sont délimitées radialement par la bordure annulaire (31) ;
- la zone d'appui (12) est formée sur la face inférieure (10ᵢ) ;
- la zone de contact (22) est formée sur la face supérieure (20ₛ).

5. Dispositif selon la revendication 4, dans lequel :
- la zone d'appui (12) est annulaire ;
- la face inférieure (10ᵢ) est creuse entre l'axe central (Z) et la zone d'appui (12), la face inférieure formant un anneau s'étendant entre la zone d'appui (12) et la bordure annulaire (31).

6. Dispositif selon l'une quelconque des revendications 4 à 5, comportant :
- un support (10) s'étendant entre un fond (10_{f}) et la face inférieure (10ᵢ), la face inférieure étant radialement délimitée par une bordure inférieure (11), annulaire autour d'un premier axe central (Z₁);
- un capot (20), s'étendant entre une face externe (20ₑ) et la face supérieure (20ₛ), la face supérieure étant radialement délimitée par une bordure supérieure (21), annulaire autour d'un deuxième axe central (Z₂) ;
le support (10) et le capot (20) sont séparables l'un de l'autre, le dispositif étant formé par un assemblage du capot (20) sur le support (10), la bordure supérieure (21) étant configurée pour être mise au contact de la bordure inférieure (11), pour former la bordure annulaire (31) du dispositif, le premier axe central (Z₁) et le deuxième axe central (Z₂) étant confondus et formant l'axe central (Z).

7. Dispositif selon la revendication 6, dans lequel la zone d'appui (12) s'étend en retrait, selon l'axe central (Z), par rapport à la bordure inférieure (11), de façon à permettre une insertion de la plaque (2) sur la zone d'appui, de telle sorte que lorsque la plaque est disposée dans le logement (30), la plaque est délimitée, au moins en partie, radialement par la bordure inférieure.

8. Dispositif selon l'une quelconque des revendications 6 ou 7, dans lequel la zone de contact (22) s'étend en retrait, selon l'axe central (Z), par rapport à la bordure supérieure (21), de telle sorte que lorsque la plaque est disposée dans le logement (30), la plaque est délimitée, au moins en partie, radialement par la bordure supérieure.

9. Dispositif selon l'une quelconque des revendications 6 à 8, dans lequel le capot et le support sont constitués de Téflon.

10. Dispositif selon l'une quelconque des revendications précédentes, comportant une ouverture fluidique (26), débouchant du dispositif, et s'étendant jusqu'à la gorge annulaire (33), l'ouverture fluidique étant configurée pour permettre une admission du liquide nettoyant (34) dans la gorge annulaire (33) ou un retrait du liquide nettoyant de la gorge annulaire.

11. Dispositif selon la revendication 10, dépendant de la revendication 6, dans lequel l'ouverture fluidique (26) débouche du capot du dispositif.

12. Dispositif selon l'une quelconque des revendications 10 ou 11, dans lequel l'ouverture fluidique (26) décrit une partie d'un anneau autour de l'axe central (Z).

13. Procédé de collecte d'éléments contaminants susceptibles d'être présents sur une plaque de semi-conducteur, à l'aide d'un dispositif selon l'une quelconque des revendications précédentes, le procédé comportant :
a) disposition de la plaque (2) sur la zone d'appui (12) du dispositif ;
b) admission d'un liquide nettoyant (34) dans la cavité annulaire (33), de façon que le liquide mouille une partie de la plaque s'étendant dans la cavité annulaire ;
c) retrait du liquide nettoyant de la cavité annulaire;
d) retrait de la plaque de la zone d'appui.

14. Procédé selon la revendication 13, dans lequel le dispositif est un dispositif selon la revendication 6, dans lequel :
- lors de l'étape a) et de l'étape d) le capot (20) est séparé du support (10);
- suite à l'étape a) et avant l'étape b), le capot (10) est placé sur le support (20).

15. Procédé de fabrication d'un dispositif selon l'une quelconque des revendications 1 à 12, le dispositif étant fabriqué par moulage ou par impression 3D.

## Patentansprüche

1. Vorrichtung (1) zur Reinigung eines Halbleiterwafers, wobei der Wafer (2) eine vordere Fläche (2_{f}) und eine hintere Fläche (2ᵣ) aufweist, wobei die vordere und die hintere Fläche um eine Dicke des Wafers (ε) beabstandet sind, wobei die Vorrichtung eine Aufnahme (30) aufweist, die dazu bestimmt ist, den Wafer aufzunehmen, wobei die Aufnahme von einer ringförmigen Umrandung (31) begrenzt wird, die sich um eine Mittelachse (Z) herum erstreckt, wobei die Aufnahme aufweist:
- einen Auflagebereich (12), der dazu bestimmt ist, den Wafer aufzunehmen, wobei sich der Auflagebereich (12) zwischen der Mittelachse (Z) und der ringförmigen Umrandung (31) erstreckt;
- einen Kontaktbereich (22), der ringförmig um die Mittelachse angeordnet ist und sich gegenüber dem Auflagebereich (12) erstreckt, wobei der Abstand zwischen dem Kontaktbereich und dem Auflagebereich entlang der Mittelachse größer oder gleich der Dicke des Wafers (ε) ist, wobei der Auflagebereich und der Kontaktbereich somit einen Spalt (32) begrenzen, der sich zwischen der Mittelachse und der ringförmigen Umrandung (31) erstreckt, derart, dass der Wafer durch den Spalt hindurch eingefügt werden kann;
- einen Hohlraum (33), der ringförmig um die Mittelachse (Z) angeordnet ist und sich radial zwischen dem Spalt (32) und der ringförmigen Umrandung (31) erstreckt, um den Wafer herum, wobei der ringförmige Hohlraum dafür ausgelegt ist, eine Reinigungsflüssigkeit (34) zu enthalten;
- derart, dass, wenn der ringförmige Hohlraum (33) die Reinigungsflüssigkeit (34) enthält, der in den Spalt (32) eingefügte Wafer (2) von der Reinigungsflüssigkeit zwischen dem Spalt (32) und der ringförmigen Umrandung (33) befeuchtet wird, wobei sich die Reinigungsflüssigkeit um den Wafer herum erstreckt;
- wobei die Vorrichtung so beschaffen ist, dass der Auflagebereich (12) und der Kontaktbereich (22) aus einem Material gebildet sind, das aus Teflon besteht oder Teflon umfasst.

2. Vorrichtung nach Anspruch 1, wobei der ringförmige Hohlraum (33) eine obere Ringnut (23) aufweist, die sich radial zwischen dem Kontaktbereich (22) und der ringförmigen Umrandung (31) erstreckt.

3. Vorrichtung nach einem der Ansprüche 1 oder 2, wobei der ringförmige Hohlraum (33) eine untere Ringnut (13) aufweist, die sich radial zwischen dem Auflagebereich (12) und der ringförmigen Umrandung (31) erstreckt.

4. Vorrichtung nach einem der vorhergehenden Ansprüche, wobei sich die Aufnahme (30) zwischen einer Unterseite (10ᵢ) und einer Oberseite (20ₛ) erstreckt, wobei die Vorrichtung so beschaffen ist, dass:
- die Unterseite (10ᵢ) und die Oberseite (20ₛ) radial von der ringförmigen Umrandung (31) begrenzt werden;
- der Auflagebereich (12) an der Unterseite (10ᵢ) ausgebildet ist;
- der Kontaktbereich (22) an der Oberseite (20ₛ)ausgebildet ist.

5. Vorrichtung nach Anspruch 4, wobei:
- der Auflagebereich (12) ringförmig ist;
- die Unterseite (10ᵢ) hohl zwischen der Mittelachse (Z) und dem Auflagebereich (12) ist, wobei die Unterseite einen Ring bildet, der sich zwischen dem Auflagebereich (12) und der ringförmigen Umrandung (31) erstreckt.

6. Vorrichtung nach einem der Ansprüche 4 bis 5, welche aufweist:
- einen Träger (10), der sich zwischen einem Boden (10_{f}) und der Unterseite (10ᵢ) erstreckt, wobei die Unterseite radial von einer unteren Umrandung (11) begrenzt wird, die ringförmig um eine erste Mittelachse (Z₁) angeordnet ist;
- eine Abdeckkappe (20), die sich zwischen einer Außenseite (20ₑ) und der Oberseite (20ₛ) erstreckt, wobei die Oberseite radial von einer oberen Umrandung (21) begrenzt wird, die ringförmig um eine zweite Mittelachse (Z₂) angeordnet ist;
wobei der Träger (10) und die Abdeckkappe (20) voneinander trennbar sind, wobei die Vorrichtung durch eine Montage der Abdeckkappe (20) auf dem Träger (10) gebildet wird, wobei die obere Umrandung (21) dafür ausgelegt ist, mit der unteren Umrandung (11) in Kontakt gebracht zu werden, um die ringförmige Umrandung (31) der Vorrichtung zu bilden, wobei die erste Mittelachse (Z₁) und die zweite Mittelachse (Z₂) zusammenfallen und die Mittelachse (Z) bilden.

7. Vorrichtung nach Anspruch 6, wobei der Auflagebereich (12) sich zurückversetzt, entlang der Mittelachse (Z), in Bezug auf die untere Umrandung (11) erstreckt, um so ein Einfügen des Wafers (2) auf dem Auflagebereich zu ermöglichen, derart, dass, wenn der Wafer in der Aufnahme (30) angeordnet ist, der Wafer wenigstens teilweise radial von der unteren Umrandung begrenzt wird.

8. Vorrichtung nach einem der Ansprüche 6 oder 7, wobei der Kontaktbereich (22) sich zurückversetzt, entlang der Mittelachse (Z), in Bezug auf die obere Umrandung (21) erstreckt, derart, dass, wenn der Wafer in der Aufnahme (30) angeordnet ist, der Wafer wenigstens teilweise radial von der oberen Umrandung begrenzt wird.

9. Vorrichtung nach einem der Ansprüche 6 bis 8, wobei die Abdeckkappe und der Träger aus Teflon bestehen.

10. Vorrichtung nach einem der vorhergehenden Ansprüche, welche eine Fluidöffnung (26) aufweist, die aus der Vorrichtung ausmündet und sich bis zu der Ringnut (33) erstreckt, wobei die Fluidöffnung dafür ausgelegt ist, ein Einlassen der Reinigungsflüssigkeit (34) in die Ringnut (33) oder ein Abziehen der Reinigungsflüssigkeit aus der Ringnut zu ermöglichen.

11. Vorrichtung nach Anspruch 10, wenn abhängig von Anspruch 6, wobei die Fluidöffnung (26) aus der Abdeckkappe der Vorrichtung ausmündet.

12. Vorrichtung nach einem der Ansprüche 10 oder 11, wobei die Fluidöffnung (26) einen Teil eines Ringes um die Mittelachse (Z) beschreibt.

13. Verfahren zum Sammeln von kontaminierenden Elementen, die auf einem Halbleiterwafer möglicherweise vorhanden sind, mithilfe einer Vorrichtung nach einem der vorhergehenden Ansprüche, wobei das Verfahren umfasst:
a) Anordnen des Wafers (2) auf dem Auflagebereich (12) der Vorrichtung;
b) Einlassen einer Reinigungsflüssigkeit (34) in den ringförmigen Hohlraum (33), so dass die Flüssigkeit einen Teil des Wafers befeuchtet, der sich in dem ringförmigen Hohlraum erstreckt;
c) Abziehen der Reinigungsflüssigkeit aus dem ringförmigen Hohlraum;
d) Entnehmen des Wafers vom Auflagebereich.

14. Verfahren nach Anspruch 13, wobei die Vorrichtung eine Vorrichtung nach Anspruch 6 ist, wobei:
- im Schritt a) und im Schritt d) die Abdeckkappe (20) vom Träger (10) getrennt wird;
- im Anschluss an den Schritt a) und vor dem Schritt b) die Abdeckkappe (20) auf den Träger (10) aufgesetzt wird.

15. Verfahren zur Herstellung einer Vorrichtung nach einem der Ansprüche 1 bis 12, wobei die Vorrichtung durch Formung oder durch 3D-Druck hergestellt wird.

## Claims

1. Device (1) for cleaning a semiconductor wafer, the wafer (2) comprising a front surface (2_{f}) and a rear surface (2ᵣ), the front and rear surfaces being spaced apart by a wafer thickness (ε), the device comprising a housing (30) designed to receive the wafer, the housing being bounded by an annular rim (31) extending around a central axis (Z), the housing comprising:
- a support zone (12), designed to receive the wafer, the support zone (12) extending between the central axis (Z) and the annular rim (31);
- a contact zone (22), annular about the central axis, extending opposite the support zone (12), the distance, along the central axis, between the contact zone and the support zone being greater than or equal to the thickness of the wafer (ε), the support zone and the contact zone thus defining a slot (32), extending between the central axis and the annular rim (31), such that the wafer can be inserted through the slot;
- an annular cavity (33) around the central axis (Z), extending radially between the slot (32) and the annular rim (31) around the wafer, the annular cavity being configured to contain a cleaning liquid (34);
- such that when the annular cavity (33) contains the cleaning liquid (34), the wafer (2), inserted into the slot (32), is wetted by the cleaning liquid between the slot (32) and the annular rim (33), with the cleaning liquid extending around the wafer;
- the device being **characterised in that** the support zone (12) and the contact zone (22) are formed from a material consisting of or comprising Teflon.

2. Device according to claim 1, wherein the annular cavity (33) comprises an upper annular cavity (23), extending radially between the contact zone (22) and the annular rim (31).

3. Device according to any one of claims 1 or 2, wherein the annular cavity (33) comprises a lower annular cavity (13) extending radially between the support zone (12) and the annular rim (31).

4. Device according to any one of the preceding claims, wherein the housing (30) extends between a lower face (10ᵢ ) and an upper face (20ₛ ), the device being such that:
- the lower face (10ᵢ ) and the upper face (20ₛ ) are radially bounded by the annular rim (31);
- the support zone (12) is formed on the lower face (10ᵢ);
- the contact zone (22) is formed on the upper face (20ₛ).

5. Device according to claim 4, wherein:
- the support zone (12) is annular;
- the lower face (10ᵢ ) is hollow between the central axis (Z) and the support zone (12), the lower face forming a ring extending between the support zone (12) and the annular rim (31).

6. Device according to any one of claims 4 to 5, comprising:
- a support (10) extending between a base (10_{f}) and the lower face (10ᵢ), the lower face being radially bounded by a lower rim (11), which is annular about a first central axis (Z₁ );
- a cover (20) extending between an outer face (20ₑ) and an upper face (20ₛ), the upper face being radially bounded by an upper rim (21) which is annular about a second central axis (Z₂ );
the support (10) and the cover (20) are separable from one another, the device being formed by assembling the cover (20) onto the support (10), the upper rim (21) being configured to be brought into contact with the lower rim (11) to form the annular rim (31) of the device, the first central axis (Z₁) and the second central axis (Z₂) coinciding and forming the central axis (Z).

7. Device according to claim 6, wherein the support zone (12) extends inwards, along the central axis (Z), relative to the lower rim (11), so as to allow the wafer (2) to be inserted onto the support zone, such that when the wafer is positioned in the housing (30), the wafer is bounded, at least in part, radially by the lower rim.

8. Device according to any one of claims 6 or 7, in which the contact zone (22) is set back, along the central axis (Z), relative to the upper rim (21), such that when the wafer is positioned in the housing (30), the wafer is bounded, at least in part, radially by the upper rim.

9. Device according to any one of claims 6 to 8, wherein the cover and the support are made of Teflon.

10. Device according to any one of the preceding claims, comprising a fluid opening (26) opening outside the device and extending to the annular cavity (33), the fluid opening being configured to allow the cleaning liquid (34) to enter the annular cavity (33) or to be withdrawn from the annular cavity.

11. Device according to claim 10, dependent on claim 6, wherein the fluid opening (26) opens out from the device housing.

12. Device according to any one of claims 10 or 11, wherein the fluid opening (26) forms part of a ring around the central axis (Z).

13. Method of collecting contaminants likely to be present on a semiconductor wafer, using a device according to any one of the preceding claims, the method comprising:
a) placing the wafer (2) on the support zone (12) of the device;
b) introducing a cleaning liquid (34) into the annular cavity (33), such that the liquid wets a portion of the wafer extending into the annular cavity;
c) removing the cleaning liquid from the annular cavity;
d) removing the wafer from the support zone.

14. Method according to claim 13, wherein the device is a device according to claim 6, wherein:
- during step (a) and step (d), the cover (20) is separated from the support (10);
- following step (a) and prior to step (b), the cover (10) is placed on the support (20).

15. Method of manufacturing a device according to any one of claims 1 to 12, the device being manufactured by moulding or by 3D printing.
